# FASCICULE DE BREVET EUROPEEN

(11) **EP 2 027 608 B1**
(45) Date de publication et mention de la délivrance du brevet: **15.08.2018**
(21) Numéro de dépôt: 07730017.6
(22) Date de dépôt: 08.06.2007
(51) Int. Cl.: H01L 33/00, H01L 33/08, H01L 33/18, C30B 25/00, C30B 29/62, H01L 33/06, H01L 33/32, H01L 33/38, H01L 33/50, C30B 29/40

(54) **PROCÉDÉ DE RÉALISATION D'UN DISPOSITIF MICROÉLECTRONIQUE ÉMETTEUR DE LUMIÈRE À NANOFILS SEMI-CONDUCTEURS FORMÉS SUR UN SUBSTRAT MÉTALLIQUE**
VERFAHREN ZUR HERSTELLUNG EINER HALBLEITERNANODRAHT-BASIERTEN LICHTEMITTIERENDEN MIKROELEKTRONISCHEN VORRICHTUNG AUF EINEM METALLSUBSTRAT
METHOD OF MANUFACTURING A SEMICONDUCTOR NANOWIRE-BASED LIGHT-EMITTING MICROELECTRONIC DEVICE ON A METALLIC SUBSTRATE

(30) Priorité: 09.06.2006 FR 0652075
(43) Date de publication de la demande: 25.02.2009
(73) Titulaire: Commissariat à l'Énergie Atomique et aux Énergies Alternatives, 75015 Paris (FR); CENTRE NATIONAL DE LA RECHERCHE SCIENTIFIQUE, 75794 Paris Cedex 16 (FR)
(72) Inventeur: GILET, Philippe, F-38470 TECHE (FR); FERRET, Pierre, F-38000 Grenoble (FR); GENTILE, Pascal, F-38500 Voiron (FR); TCHELNOKOV, Alexei, F-38000 Grenoble (FR); BARON, Thierry, F-38120 Saint Egreve (FR)
(74) Mandataire: Ilgart, Jean-Christophe
(86) Numéro de dépôt international: PCT/EP2007/055661
(87) Numéro de publication internationale: WO 2007/141333

(56) Documents cités:
- WO-A-2004/087564
- WO-A-2006/000790
- US-A1- 2005 199 886
- KIKUCHI A ET AL: "INGAN/GAN MULTIPLE QUANTUM DISK NANOCOLUMN LIGHT-EMITTING DIODES GROWN ON (111) SI SUBSTRATE" JAPANESE JOURNAL OF APPLIED PHYSICS, JAPAN SOCIETY OF APPLIED PHYSICS, TOKYO, JP, vol. 43, no. 12A, 1 décembre 2004 (2004-12-01), pages L1524-L1526, XP001230716 ISSN: 0021-4922
- BERESFORD R ET AL: "Group IVB refractory metal crystals as lattice-matched substrates for growth of the group III nitrides by plasma-source molecular beam epitaxy" JOURNAL OF CRYSTAL GROWTH, ELSEVIER, AMSTERDAM, NL, vol. 178, no. 1-2, juin 1997 (1997-06), pages 189-200, XP004084985 ISSN: 0022-0248
- HIRUMA K ET AL: "GAAS FREE-STANDING QUANTUM-SIZE WIRES" JOURNAL OF APPLIED PHYSICS, AMERICAN INSTITUTE OF PHYSICS. NEW YORK, US, vol. 74, no. 5, 1 septembre 1993 (1993-09-01), pages 3162-3171, XP009071551 ISSN: 0021-8979
- KIM H-M ET AL: "High-Brightness Light Emitting Diodes Using Dislocation-Free Indium Gallium Nitride/Gallium Nitride Multiquantum-Well Nanorod Arrays" NANO LETTERS, ACS, WASHINGTON, DC, US, vol. 4, no. 6, 19 mai 2004 (2004-05-19), pages 1059-1062, XP002368212 ISSN: 1530-6984
- KIPSHIDZE G ET AL: "Controlled growth of GaN nanowires by pulsed metalorganic chemical vapor deposition" APPLIED PHYSICS LETTERS, AIP, AMERICAN INSTITUTE OF PHYSICS, MELVILLE, NY, US, vol. 86, no. 3, 11 janvier 2005 (2005-01-11), pages 33104-33104, XP012066127 ISSN: 0003-6951

## Description

### DOMAINE TECHNIQUE

Le domaine technique auquel se rapporte l'invention est celui de la microélectronique et de l'optoélectronique et plus spécifiquement la réalisation d'émetteurs de lumière à base de matériaux semi-conducteurs.

L'invention concerne un procédé de réalisation d'un dispositif émetteur de lumière comprenant une pluralité de nanofils formés sur un substrat métallique.

### ART ANTÉRIEUR

La réalisation d'un dispositif microélectronique émetteur de lumière, par exemple de type LED (LED pour « Light Emitting Diode » en anglais, ou diode électroluminescente) peut être effectuée, de manière courante, à l'aide d'épitaxies successives de plusieurs couches minces de matériaux semi-conducteurs. Des substrats à base de saphir, ou des substrats à base de carbure de silicium sont généralement utilisés pour former ce type de dispositif. La taille de ces substrats est souvent inférieure à 3 pouces (7,62 centimètres), ce qui limite le nombre de LED intégrables sur un même substrat.

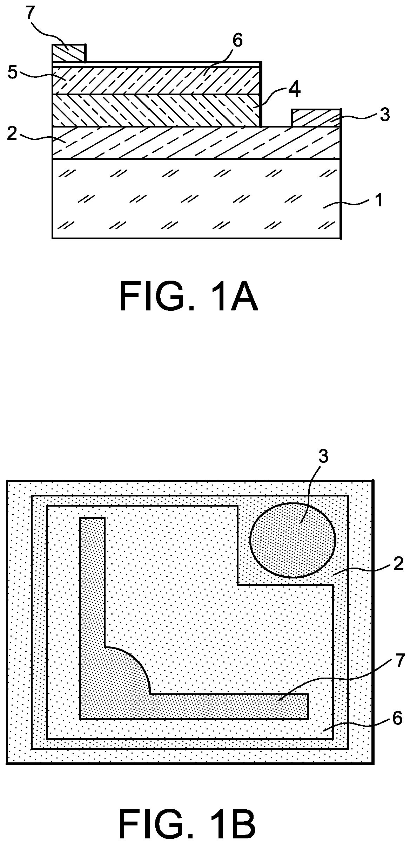

Par exemple, pour une LED émettant de la lumière à 450 nm, l'empilement suivant peut être réalisé : sur un substrat 1 de type saphir, une couche tampon 2 à base de GaN dopée N est formée et sert à une prise de contact inférieur 3, puis une pluralité de puits quantiques formés respectivement dans une couche à base d'InGaN et une couche à base de GaN superposées, puis une couche 5 de GaN dopé au magnésium et enfin une fine couche 6 de GaN fortement dopée P sur laquelle un contact supérieur 7 est formé (figure 1A et figure 1B).

Le désaccord de maille entre le saphir (substrat) et le GaN de la couche tampon est généralement important, ce qui induit un taux de dislocations élevé dans les autres couches semiconductrices. D'autre part, compte tenu du caractère isolant du saphir, la réalisation de la prise de contact inférieur, requiert une gravure de la couche active 4, qui alourdit le procédé de réalisation. Avec une telle disposition du contact inférieur, l'injection de courant n'est pas homogène sur la face inférieure de la diode. Par ailleurs, lorsque le dispositif est en fonctionnement la couche active 4 est susceptible d'émettre de la lumière dans toutes les directions. Le saphir (substrat) 1 étant un matériau transparent à la longueur d'onde d'émission de la diode, environ la moitié de la lumière émise en direction de la face arrière est perdue. Le substrat de saphir étant isolant électriquement, une fine couche de matériau semi-conducteur dopé est généralement formée sur ce dernier, pour pouvoir réaliser un plan de masse. La conductivité électrique de la couche qui assure le passage du courant, par exemple à base de GaN dopé N, est généralement faible. Lors du passage du courant au sein de la diode, il en résulte un échauffement important du dispositif par effet joule. Cet échauffement important dû à une mauvaise dissipation de la chaleur par le substrat 1 (la conductivité thermique des substrats de saphir étant généralement de l'ordre de 35 à 40 W/mK), peut induire des dégradations rapides du matériau et diminuer la fiabilité de la couche active de la LED. Un tel type d'échauffement peut diminuer les propriétés électriques de la couche active et détériorer le rendement de la LED.

Dans le document WO 02/080280 A1 la réalisation d'un dispositif microélectronique émetteur de rayons lumineux comportant des nano-fils que l'on fait croître sur un support a été envisagée.

Le document US 2003/0168964 A1 présente quant à lui un procédé de réalisation d'une LED formé de nano-fils réalisés sur un substrat conducteur semi-transparent. Dans ce procédé, la croissance des nanofils s'effectue sur une couche conductrice semi-transparente de type ITO (ITO pour Indium Tin Oxide) ou à base de ZnO. Les performances électriques et en termes de rendement d'un tel dispositif peuvent s'avérer insuffisantes. L'article de KIKUCHI A. et al.: "InGaN/GaN Multiple Quantum Disk Nanocolumn Light-Emitting Diodes Grown on (111) Si Substrate" JAPANESE JOURNAL OF APPLIED PHYSICS, vol. 43, no. 12A, 5 novembre 2004, pages L1524-L1526, présente un procédé de réalisation d'un dispositif microélectronique émetteur de lumière comprenant la croissance de nano-fils directement sur un substrat de silicium type N et orienté (111). Le document WO 2004/087564 A1 présente un autre procédé de réalisation d'un dispositif microélectronique émetteur de lumière comprenant des nano-fils et utilisant, cette fois-ci, un catalyseur pour leur croissance. Le document WO 2006/000790 A1 présente un procédé de réalisation de dispositifs microélectroniques comprenant la croissance sur un support en un matériau donné d'une pluralité de fils en un matériau différent; fils susceptibles d'émettre un rayonnement lumineux. Le document US 2005/0199886 A1 présente un procédé de réalisation d'un dispositif microélectronique émetteur de lumière comprenant des nano-fils. Une variété de substrats de croissance pour ces nano-fils est envisagée dans ce document.

Il se pose le problème de trouver un nouveau dispositif microélectronique émetteur de lumière à nano-fils semi-conducteurs ainsi qu'un nouveau procédé de réalisation d'un tel dispositif.

### EXPOSÉ DE L'INVENTION

L'invention concerne un procédé de réalisation d'un dispositif microélectronique émetteur de lumière, comprenant les étapes de :
a) croissance sur un support métallique d'une pluralité de fils à base d'un ou plusieurs matériaux semi-conducteurs susceptibles d'émettre un rayonnement lumineux, ledit support métallique étant apte à réfléchir ledit rayonnement lumineux,
b) formation d'au moins une zone de contact conductrice de l'électricité sur au moins un desdits fils.

La croissance des fils est directement effectuée sur une couche métallique dudit support.

Ainsi, la présente invention prévoit un procédé de réalisation d'un dispositif microélectronique émetteur de lumière, comprenant les étapes de :
a) croissance sur une couche métallique continue de substrat appartenant à un support métallique, ou sur une fine couche métallique continue d'un support métallique, d'une pluralité de fils à base d'un ou plusieurs matériaux semi-conducteurs susceptibles d'émettre un rayonnement lumineux, ledit substrat ou ladite fine couche métallique étant apte à réfléchir ledit rayonnement lumineux,
b) formation d'au moins une zone de contact conductrice de l'électricité sur au moins un desdits fils.

Selon une possibilité, le support métallique peut comprendre un substrat à base d'un métal ou d'un alliage métallique, le métal ou l'alliage métallique comprenant au moins un des matériaux suivants : fer, nickel, aluminium, argent, cuivre, inox, d'alliage de fer et de Ni tel que l'invar®.

Les fils formés à l'étape a) peuvent être en contact avec le substrat.

Selon une variante, pour laquelle le substrat est recouvert d'une fine couche métallique, les fils formés à l'étape a) peuvent être en contact avec ladite fine couche.

Ladite fine couche est prévue pour réfléchir ledit rayonnement lumineux.

Le procédé peut également comprendre, préalablement à l'étape a), le dépôt d'une couche de matériau catalyseur sur le support métallique.

Le procédé peut également comprendre, entre l'étape a) et l'étape b), la formation d'une couche isolante d'encapsulation des fils.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1B, illustrent, un dispositif microélectronique de type LED selon l'art antérieur, respectivement suivant une vue en coupe et suivant une vue de dessus ;
- les figures 2A à 2D, illustrent un procédé suivant l'invention de réalisation d'un dispositif microélectronique de type LED doté de nano-fils formés sur un substrat métallique ;
- la figure 3, illustre une variante de procédé suivant l'invention de réalisation d'un dispositif microélectronique de type LED doté de nano-fils formés sur un substrat métallique.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

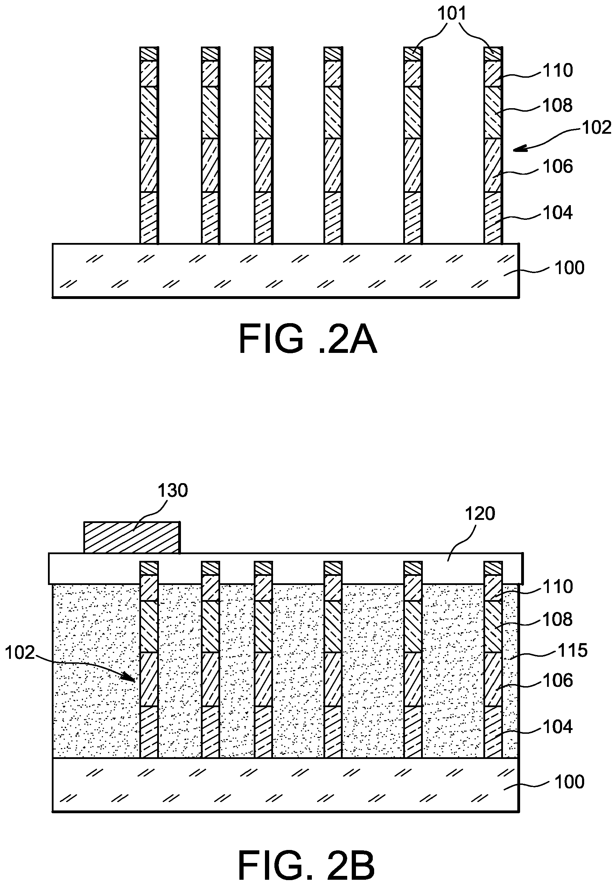

Un exemple de procédé de réalisation suivant l'invention d'un dispositif microélectronique émetteur de lumière (LED), va à présent être donné en liaison avec les figures 2A-2D. Le matériau de départ du procédé est un substrat métallique 100, qui peut être à base d'un métal tel que de l'aluminium ou de l'argent ou du cuivre, ou d'un alliage métallique par exemple à base d'aluminium ou d'argent ou de cuivre ou tel que de l'inox ou un alliage FeNi, comportant du fer et du nickel tel que l'invar® (marque déposée par la société Goodfellow). Le substrat métallique 100 peut avoir une épaisseur comprise par exemple entre 10 µm et 10 mm, ou par exemple de l'ordre de 1 mm, et une surface par exemple comprise entre 100 mm² et 1 m², ou par exemple de l'ordre de 300 mm².

Une étape de préparation du substrat 100, et en particulier d'une face donnée de ce dernier en vue d'une croissance de fils à base d'un ou plusieurs matériaux semi-conducteurs peut être réalisée à l'aide d'un traitement de surface, comprenant par exemple une étape de dégraissage du substrat à l'aide d'un solvant par exemple à base d'acétone et d'éthanol, et une étape d'élimination des rugosités par exemple à l'aide d'un polissage sur un feutre. Un matériau 101 destiné à servir de catalyseur peut être ensuite déposé sous forme d'une fine couche par exemple de l'ordre de 5 nanomètres, sur ladite face donnée du substrat 100. Le matériau catalyseur 101 peut être par exemple de l'or ou du nickel formé par évaporation. Ensuite, on fait croître sur le substrat 100, une pluralité de fils 102 dits « nano-fils », à base d'un ou plusieurs matériaux semi-conducteurs susceptibles d'émettre un rayonnement lumineux. Les nano-fils 102 peuvent être réalisés par épitaxie.

Les nano-fils 102 sont destinés à croître dans une direction réalisant un angle non nul, par exemple dans une direction orthogonale avec le plan principal du substrat 100 (le plan principal du substrat 100 étant défini comme un plan passant par le substrat 100 et parallèle au plan [O;*i̅;k̅*] d'un repère orthogonal [O;*̅i̅*̅;*̅j̅*̅;*̅k̅*̅] sur la figure 2A). Les nano-fils 102 que l'on fait croître peuvent être formés d'une ou plusieurs portions comportant du nitrure de gallium ou un composé à base de nitrure de gallium. Pour cela, le substrat métallique 100 peut être placé par exemple dans une chambre d'un réacteur de type MOCVD (méthode de dépôt chimique en phase vapeur de matériau semi-conducteur ou de métal à partir de matériaux organiques). Le substrat 100 est porté à haute température par exemple de l'ordre de 500 à 800°C pour mettre le matériau catalyseur 101 sous forme de gouttelettes et le rendre actif. Ensuite, un ou plusieurs précurseurs sont introduits dans la chambre de réaction. Pour réaliser une première portion 104 des fils 102 à base d'un premier matériau, par exemple du GaN dopé N en contact avec le substrat métallique 100, des précurseurs tels que du triméthylgallium et de l'ammoniac peuvent être par exemple injectés dans la chambre du réacteur. Le dopage de type N de la première portion 104 peut être réalisé à l'aide d'une injection de silane. Pendant la croissance des nano-fils 102, la température du substrat 100 peut être comprise par exemple entre 500°C et 1000°C. La composition chimique des nano-fils 102 est destinée à varier le long de leur axe de croissance. La première portion 104 des fils quantiques de GaN dopé N, peut être recouverte par exemple par une deuxième portion 106 dans laquelle des puits quantiques, à base de InGaN et du GaN peuvent être formés. La deuxième portion peut être recouverte par une troisième portion 108, par exemple à base de GaN dopé P, elle même recouverte par une quatrième portion 110 à base de GaN dopé P++, et servant par exemple à la prise de contact (s). Le dopage de type P peut être réalisé par exemple par injection d'un organométallique à base de Mg. Une fois les nano-fils 102 formés, l'extrémité de ces derniers peut être recouverte du matériau catalyseur 101. Les nanofils 102 obtenus peuvent avoir un diamètre (mesuré dans une direction parallèle au vecteur *̅i̅*̅ du repère orthogonal [O;*i̅;j̅;k̅*]) compris par exemple entre 5 nanomètres et 500 nanomètres et une longueur comprise par exemple entre 100 nanomètres et 10 micromètres (mesurée dans une direction parallèle au vecteur *̅j̅*̅ du repère [O;*̅i̅*̅;*j̅;k̅*]). La variation de composition chimique le long des fils 102 est obtenue par variation au cours du procédé de croissance de la composition chimique et de la concentration des gaz introduits dans le réacteur, combinée à une variation de la température à laquelle le substrat 100 est placé (figure 2A).

Une couche d'encapsulation peut être ensuite formée sur le substrat 100, et de part et d'autre des nano-fils 102, de sorte que les nano-fils 102 sont insérés dans la couche d'encapsulation 115. Une partie des nano-fils 102, par exemple une partie de la quatrième portion 110 de ces derniers, dépasse de la couche d'encapsulation 115. La couche d'encapsulation 115 peut être à base d'un matériau diélectrique choisi de manière à conférer une bonne planéité. La couche d'encapsulation 115 peut être par exemple à base de benzocyclobutène (BCB) ou de polystyrène et peut être réalisée par exemple par dépôt.

Ensuite, un contact supérieur 120 peut être formé sur la couche d'encapsulation 115, de manière à recouvrir l'extrémité des fils dépassant de la couche d'encapsulation 115. Le contact supérieur 120 peut être formé par exemple par dépôt d'une couche d'un matériau conducteur de l'électricité et semi-transparent comme de l'ITO (ITO pour "indium tin oxide" en anglais), ou d'une fine couche de Ti par exemple de l'ordre de 5 nanomètres recouverte par une autre fine couche d'Au par exemple de l'ordre de 5 nanomètres, ou d'un dépôt de nanotubes de carbone.

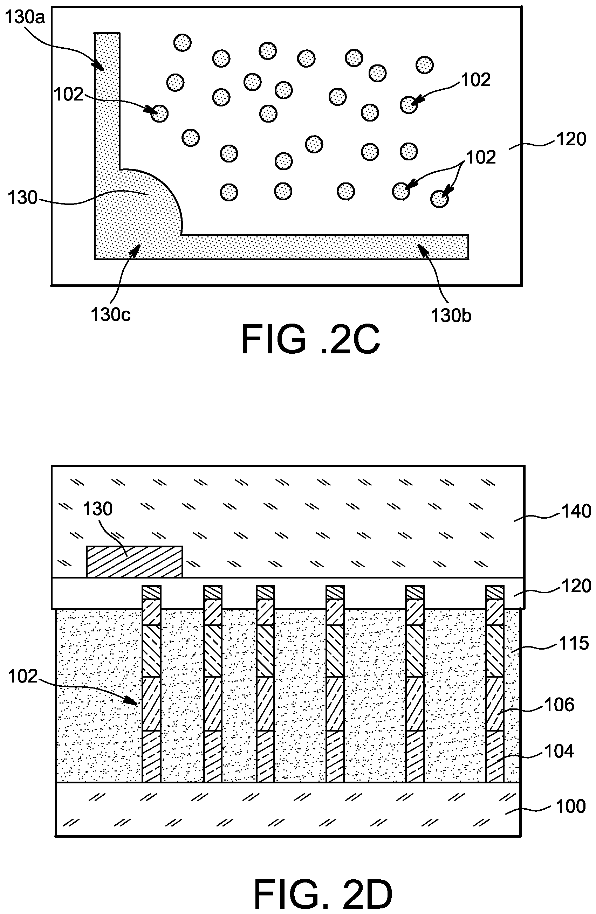

Ensuite, un zone métallique 130 de prise de contact peut être formée sur le contact 120. La zone métallique 130 peut être réalisée par exemple par dépôt d'une couche de Ti de l'ordre de 10 nanomètres, puis d'une couche d'or de l'ordre de 200 nanomètres, puis par gravure de ces couches, de manière à former un motif (figure 2B sur laquelle le dispositif est représenté selon une vue en coupe, et figure 2C, le dispositif étant représenté selon une vue de dessus). La zone de contact peut comporter une ou plusieurs parties 130a, 130b destinées à acheminer un courant électrique. La zone de contact peut éventuellement comporter une partie 130c prévue pour recevoir une soudure.

Une couche de matériau 140 dit « luminophore » (ou « phosphor » en anglais), apte à convertir une lumière quasi-monochromatique en lumière dite blanche peut être ensuite réalisée, de manière à recouvrir la zone métallique 130 de prise de contact et le contact 120. Le matériau 140 peut être par exemple un matériau YAG (YAG pour « yttrium-aluminium garnet » en anglais ou « grenat d'yttrium-aluminium ») dopé au Cérium ou Y₃Al₅O₁₂:Ce3+ (figure 2D). Le substrat 100 étant métallique, ce dernier peut être destiné à former un deuxième contact, et peut former par exemple un plan de masse. Le substrat métallique 100 est également destiné, selon la présente invention, à réfléchir des rayonnements lumineux susceptibles d'être émis par les nano-fils 102. Un rayonnement lumineux émis en direction de la face arrière du dispositif, autrement dit en direction du substrat 100, est ainsi apte à être réfléchi et redirigé en direction de la face avant. Dans un cas où le substrat 100 est à base d'argent ou d'aluminium, la réflectivité peut être supérieure à 85 % pour des rayonnements supérieurs à 380 nm.

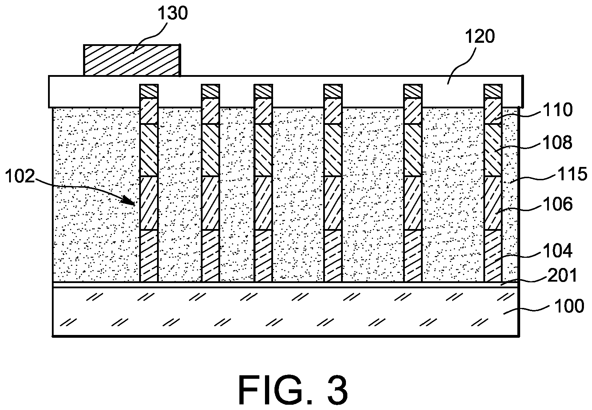

Selon une variante de procédé en accord avec la présente invention (figure 3), pour améliorer le phénomène de croissance et en particulier de nucléation des nano-fils 102 à la surface du substrat métallique 100, préalablement à l'étape de dépôt du catalyseur 101, une fine couche intermédiaire 201, et qui peut être comprise par exemple entre plusieurs nanomètres et plusieurs microns, peut être formée sur le substrat métallique 100. La fine couche intermédiaire 201 est métallique et peut être par exemple à base d'un siliciure de fer, ou du nickel, ou de l'argent, de l'aluminium, du cuivre. La fine couche métallique intermédiaire 201 est de préférence conductrice de l'électricité. Selon cette variante en accord avec le procédé de la présente invention, la fine couche métallique intermédiaire 201 joue le rôle d'une couche réfléchissante et est ainsi apte à réfléchir des rayonnements lumineux destinés à être émis par les nano-fils 102.

## Revendications

1. Procédé de réalisation d'un dispositif microélectronique émetteur de lumière, comprenant les étapes de :
a) croissance sur une couche métallique continue de substrat (100) appartenant à un support métallique, ou sur une fine couche métallique (201) d'un support métallique, d'une pluralité de fils (102) à base d'un ou plusieurs matériaux semi-conducteurs susceptibles d'émettre un rayonnement lumineux, ledit substrat ou ladite fine couche (201) métallique, étant apte à réfléchir ledit rayonnement lumineux,
b) formation d'au moins une zone de contact conductrice (120) de l'électricité sur au moins un desdits fils.

2. Procédé de réalisation d'un dispositif microélectronique émetteur de lumière selon la revendication 1, dans lequel ledit substrat (100) est à base d'un métal ou d'un alliage métallique comprenant l'un des matériaux suivants : fer, nickel, aluminium, argent, cuivre.

3. Procédé de réalisation d'un dispositif microélectronique émetteur de lumière selon l'une des revendications 1 ou 2, comprenant préalablement à l'étape a), le dépôt d'une couche de matériau catalyseur (101) sur le support métallique.

4. Procédé de réalisation d'un dispositif microélectronique émetteur de lumière selon l'une des revendications 1 à 3, comprenant en outre : entre l'étape a) et l'étape b), la formation d'une couche isolante d'encapsulation (115) des fils.

## Patentansprüche

1. Verfahren zum Herstellen einer mikroelektronischen lichtemittierenden Vorrichtung, umfassend die Schritte:
a) Wachsen einer Mehrzahl von Leitungen (102) auf Grundlage von einem oder mehreren Halbleiter-Materialien, welche in der Lage sind, Lichtstrahlung zu emittieren, auf einer kontinuierlichen metallischen Substratschicht (100), welche einem metallischen Träger zugehörig ist, oder auf einer dünnen metallischen Schicht (201) eines metallischen Trägers, wobei das Substrat oder die dünne metallische Schicht (201) in der Lage sind, die Lichtstrahlung zu reflektieren,
b) Bilden von wenigstens einer elektrisch leitfähigen Kontaktzone (120) an wenigstens einer der Leitungen.

2. Verfahren zum Herstellen einer mikroelektronischen lichtemittierenden Vorrichtung nach Anspruch 1, wobei das Substrat (100) auf Grundlage eines Metalls oder metallischen Legierung ist, umfassend eines der folgenden Materialien: Eisen, Nickel, Aluminium, Silber, Kupfer.

3. Verfahren zum Herstellen einer mikroelektronischen lichtemittierenden Vorrichtung nach einem der Ansprüche 1 oder 2, umfassend vor dem Schritt a) ein Ablagern einer Schicht aus Katalysatormaterial (101) an dem metallischen Träger.

4. Verfahren zum Herstellen einer mikroelektronischen lichtemittierenden Vorrichtung nach einem der Ansprüche 1 bis 3, ferner umfassend: zwischen dem Schritt a) und dem Schritt b) ein Bilden einer isolierenden Verkapselungsschicht (115) für die Leitungen.

## Claims

1. A method for making a light-emitting microelectronic device comprising the steps of:
a) growing on a continuous substrate metal layer (100) belonging to a metal support, or a thin metallic layer of a metal support a plurality of wires (102) based on one or several semiconducting materials capable of emitting light radiation, the substrate or said thin metallic layer being capable of reflecting said light radiation,
b) forming at least one electrically conducting contact area (120) on at least one of said wires.

2. The method for making a light-emitting microelectronic device according to claim 1, wherein said substrate (100) is formed with a metal or a metal alloy, comprises one of the following materials: iron, nickel, aluminum, silver, copper.

3. The method for making a light-emitting microelectronic device according to any of claims 1 or 2, comprising prior to step a), the depositing of a catalyst material layer on the metal support.

4. The method for making a light-emitting microelectronic device according to any of claims 1 to 3, further comprising: between step a) and step b), the formation of an insulating layer for encapsulating the wires.
